(19) **Europäisches Patentamt**
**European Patent Office**
**Office européen des brevets**

(11) **EP 3 928 428 B1**

(12) **FASCICULE DE BREVET EUROPEEN**

(45) Date de publication et mention de la délivrance du brevet:
**21.08.2024 Bulletin 2024/34**

(21) Numéro de dépôt: **20704884.4**

(22) Date de dépôt: **17.02.2020**

(51) Classification Internationale des Brevets (IPC):
**H03F 7/02** *(2006.01)*    **H03F 19/00** *(2006.01)*

(52) Classification Coopérative des Brevets (CPC):
**H03F 7/02; H03F 19/00; H10N 69/00**

(86) Numéro de dépôt international:
**PCT/EP2020/054025**

(87) Numéro de publication internationale:
**WO 2020/169503 (27.08.2020 Gazette 2020/35)**

(54) **AMPLIFICATEUR PARAMÉTRIQUE À ONDE PROGRESSIVE À BASSE IMPÉDANCE CARACTÉRISTIQUE ET SON PROCÉDÉ DE FABRICATION**

**PARAMETRISCHER VERSTÄRKER MIT PROGRESSIVER WELLE UND NIEDRIGEM WELLENWIDERSTAND UND VERFAHREN ZU SEINER HERSTELLUNG**

**PROGRESSIVE WAVE, LOW CHARACTERISTIC IMPEDANCE PARAMETRIC AMPLIFIER AND MANUFACTURING METHOD THEREOF**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.02.2019 FR 1901767**

(43) Date de publication de la demande:
**29.12.2021 Bulletin 2021/52**

(73) Titulaire: **Centre national de la recherche scientifique**
**75016 Paris (FR)**

(72) Inventeurs:
• **ROCH, Nicolas**
  **38000 GRENOBLE (FR)**
• **PLANAT, Luca**
  **38000 GRENOBLE (FR)**

(74) Mandataire: **IPAZ**
**Bâtiment Platon**
**Parc Les Algorithmes**
**91190 Saint-Aubin (FR)**

(56) Documents cités:
**US-A- 4 158 177**

• **LUCA PLANAT ET AL: "Understanding the saturation power of Josephson Parametric Amplifiers made from SQUIDs arrays", ARXIV.ORG, CORNELL UNIVERSITY LIBRARY, 201 OLIN LIBRARY CORNELL UNIVERSITY ITHACA, NY 14853, 22 September 2018 (2018-09-22), XP081201401, DOI: 10.1103/PHYSREVAPPLIED.11.034014**
• **SHAN WENLEI ET AL: "Parametric Amplification in a Superconducting Microstrip Transmission Line", IEEE TRANSACTIONS ON APPLIED SUPERCONDUCTIVITY, IEEE SERVICE CENTER, LOS ALAMITOS, CA, US, vol. 26, no. 6, 1 September 2016 (2016-09-01), pages 1 - 9, XP011614633, ISSN: 1051-8223, [retrieved on 20160617], DOI: 10.1109/TASC.2016.2555914**
• **BEDRA SAMI ET AL: "High-Tcsuperconducting rectangular microstrip patch covered with a dielectric layer", PHYSICA C, vol. 524, 15 May 2016 (2016-05-15), pages 31 - 36, XP029499149, ISSN: 0921-4534, DOI: 10.1016/J.PHYSC.2016.03.005**
• **SAPTARSHI CHAUDHURI ET AL: "Broadband parametric amplifiers based on nonlinear kinetic inductance artificial transmission lines", ARXIV.ORG, CORNELL UNIVERSITY LIBRARY, 201 OLIN LIBRARY CORNELL UNIVERSITY ITHACA, NY 14853, 4 April 2017 (2017-04-04), XP080760526, DOI: 10.1063/1.4980102**

**Description**

L'invention porte sur un amplificateur paramétrique à supraconducteur du type à onde progressive. Plus particulièrement, elle porte sur un tel amplificateur présentant une impédance caractéristique relativement faible, par exemple de l'ordre de 50 Ohm.

Les amplificateurs paramétriques sont bien connus en optique non linéaire. Ils exploitent des effets non-linéaires du deuxième ordre (mélange à trois ondes) ou du troisième ordre (mélange à quatre ondes) pour transférer de l'énergie d'un faisceau optique de pompe à un signal optique à amplifier. Un mélange à quatre ondes peut être obtenu dans une fibre optique, ce qui permet d'obtenir une grande longueur d'interaction entre la pompe et le signal, et donc un gain élevé.

Plus récemment, des amplificateurs paramétriques ont été réalisés dans le domaine des radiofréquences et plus particulièrement des hyperfréquences (1 - 300 GHz). Ces amplificateurs utilisent des composants électroniques présentant un comportement non-linéaire. Il peut s'agir, par exemple, d'éléments supraconducteurs tels des jonctions Josephson ou des SQUID (dispositifs supraconducteurs à interférence quantique - « superconducting quantum interférence devices » en anglais - constitués de deux jonctions Josephson montés en parallèle dans une boucle supraconductrice). Les jonctions Josephson et les SQUID présentent une inductance cinétique qui dépend quadratiquement de la densité de courant, et joue donc un rôle équivalent à l'effet Kerr (non-linéarité du troisième ordre) en optique. Dans le cas des SQUID, en outre, la valeur de cette inductance non-linéaire peut être ajustée en faisant varier le flux magnétique qui traverse le dispositif.

L'intérêt principal des amplificateurs paramétriques à radiofréquences / hyperfréquences réside dans leur très faible niveau de bruit, proche de la limite quantique et inférieur d'un ordre de grandeur aux meilleurs amplificateurs à semi-conducteur disponibles.

Le gain procuré par un élément non-linéaire agissant en tant qu'amplificateur paramétrique est très faible. Pour obtenir des gains significatifs, deux approches sont possibles :

- Amplificateur à onde stationnaire : le ou les éléments non linéaires sont placés dans une cavité résonante. Cela a également l'effet de réduire très fortement la bande passante, ce qui peut être un grave inconvénient dans certaines applications.
- Amplificateur à onde progressive : de nombreux éléments non-linéaires connectés en série forment une ligne de transmission le long de laquelle le signal se propage. Cette dernière approche permet d'obtenir une bande passante plus large, mais à la condition de maintenir la condition d'accord de phase entre la pompe et le signal à amplifier, ce qui nécessite de maîtriser la dispersion de la ligne de transmission. Ce problème est d'ailleurs bien connu en optique.

US 2012/0098594 et l'article de (Eom 2012) décrivent des amplificateurs paramétriques à onde progressive qui exploitent l'inductance cinétique non-linéaire d'éléments supraconducteurs formant une ligne de transmission. Dans les dispositifs décrits par ces documents, le contrôle de la dispersion permettant d'atteindre la condition d'accord de phase est obtenu par une modulation spatiale périodique de la structure de la ligne de transmission.

(Shan 2016) divulgue un amplificateur paramétrique à onde progressive qui exploite l'inductance cinétique non-linéaire d'une ligne conductrice en NNbTiN dans une configuration de type « microstrip inversé ».

US 2018/0034425 décrit un amplificateur paramétrique à onde progressive basé sur une chaîne de SQUID. L'accord de phase est obtenu en contrôlant le flux magnétique à travers les SQUID. Le document ne fournit pas de détails sur la mise en oeuvre concrète de l'amplificateur.

Les articles (White 2015) et (Macklin 2015), décrivent des amplificateurs paramétriques à onde progressive basés sur une ligne de transmission formée par des jonctions Josephson et des condensateurs à plaques parallèles reliés à la masse. L'accord de phase est obtenu en insérant dans la structure, à intervalles réguliers, des résonateurs LC parallèles.

L'article (Planat 2018) décrit un amplificateur paramétrique résonant utilisant une chaîne d'éléments supraconducteurs formant un résonateur supraconducteur non-linéaire.

Les amplificateurs paramétriques doivent être reliés à des systèmes électroniques externes - par exemple des générateurs de signaux radiofréquences - qui présentent le plus souvent une impédance de 50 Ohm, et généralement inférieure à 100 Ohm. Afin de minimiser les pertes par réflexion il est important, dans les amplificateurs à onde progressive (mais pas dans les amplificateurs résonants du type de (Planat 2018)), que l'impédance caractéristique de la ligne de transmission non linéaire prenne, autour de son point de fonctionnement, une valeur aussi proche que possible de l'impédance d'entrée ou sortie des systèmes électroniques auxquels l'amplificateur doit être relié.

L'impédance caractéristique $Z_0$ d'une ligne de transmission est donnée par

[Math. 1]

$$Z_0 = \sqrt{\frac{L}{C}}$$

où L est l'inductance par unité de longueur et C la capacité par unité de longueur.

Or, une jonction Josephson présente typiquement une inductance de l'ordre de quelques dizaines ou centaines de pH (picoHenry). Pour obtenir une impédance caractéristique de l'ordre de quelques dizaines ou centaines de Ohms, il est donc nécessaire d'y associer une capacité de quelques fF (femtoFarad). Pour cette raison, les amplificateurs paramétriques décrits dans (White 2015) et (Macklin 2015) comprennent des condensateurs concentrés qui sont sensiblement plus grands que les jonctions Josephson. Cette approche nuit à la compacité de l'amplificateur paramétrique. En outre, il faut veiller à ce que le diélectrique des condensateurs n'introduise pas des pertes dégradant les performances de l'amplificateur.

L'invention vise à surmonter les inconvénients précités de l'art antérieur. Plus particulièrement, elle vise à procurer un amplificateur paramétrique à onde progressive compact, présentant néanmoins une impédance caractéristique faible (typiquement, mais pas nécessairement, inférieure à 100 Ohm et de préférence d'environ 50 Ohm).

Conformément à l'invention, ce but est atteint en utilisant une structure qu'on peut qualifier de « microstrip inversé », dans laquelle la chaîne de jonctions Josephson ou SQUID est recouverte d'une couche diélectrique de quelques dizaines de nanomètres d'épaisseur, fabriquée par dépôt de couches atomiques (ALD, de l'anglais « Atomic Layer Déposition »), sur lequel est déposé un plan de masse. L'ensemble se comporte comme une ligne de transmission de type « microstrip », mais avec une capacité par unité de longueur de plusieurs ordres de grandeurs supérieure à celle qui serait obtenue si, de manière conventionnelle, le plan de masse était réalisé sur la face arrière du substrat, dont l'épaisseur est généralement d'au moins 100 μm. De cette façon, une impédance caractéristique de l'ordre de quelques dizaines ou centaines de Ohm peut être obtenue sans avoir recours à des condensateurs à paramètres concentrés. La fabrication de la couche de diélectrique par ALD assure une excellente qualité du matériau et donc de faibles pertes.

Selon un mode de réalisation de l'invention, pour optimiser ultérieurement la miniaturisation de l'amplificateur paramétrique, l'accord de phase est obtenu en modulant spatialement de manière périodique les dimensions des jonctions Josephson ou SQUID, plutôt qu'en introduisant des oscillateurs LC.
Un amplificateur paramétrique selon l'invention peut être fabriqué de manière simple, en ayant recours à des technologies bien maîtrisées.

Un objet de l'invention est donc un amplificateur paramétrique supraconducteur à onde progressive selon la revendication 1.

Un autre objet de l'invention est un procédé de fabrication d'un tel amplificateur paramétrique à onde progressive.

Les dessins annexés illustrent l'invention :

[Fig.1A], [Fig. 1B] et [Fig. 1C] représentent un amplificateur paramétrique selon un mode de réalisation de l'invention à différentes étapes de sa fabrication ;

[Fig.2A] et [Fig. 2B] sont des vues de détail des figures 1B et 1C, respectivement ;

[Fig. 3] illustre schématiquement une modulation de taille des éléments supraconducteurs permettant d'obtenir un accord de phase ;

[Fig. 4] est un graphique illustrant la relation de dispersion d'un amplificateur paramétrique du type de la figure 1C ;

[Fig. 5] est un graphique illustrant les pertes dans cet amplificateur paramétrique ; et

[Fig. 6] est un graphique illustrant le profil de gain du même amplificateur paramétrique.

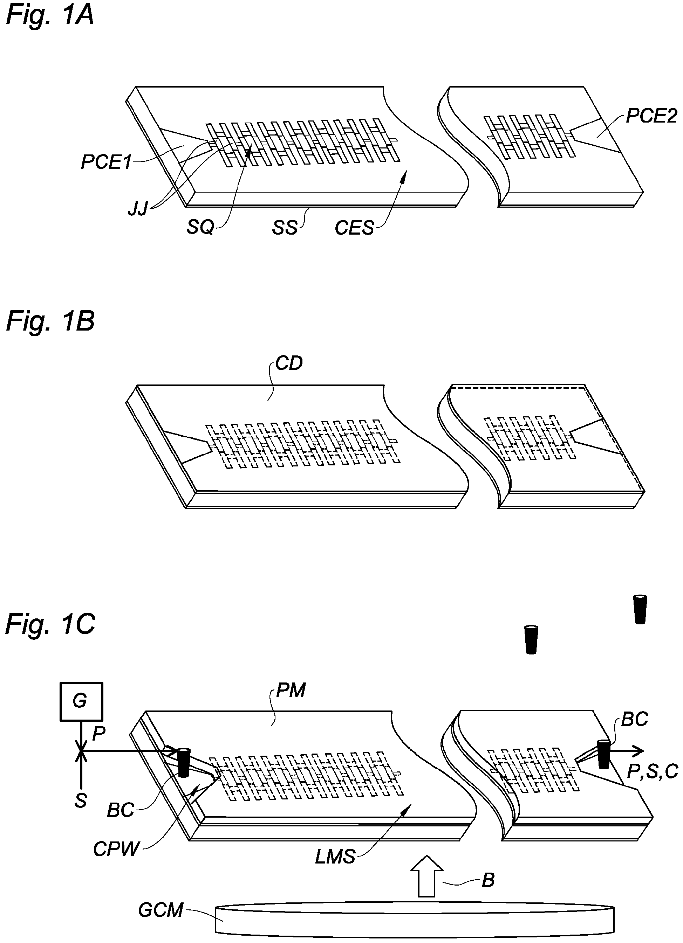

La fabrication d'un amplificateur paramétrique à onde progressive selon l'invention comporte trois étapes principales, illustrées par les Fig. 1A, Fig. 1B et Fig. 1C, respectivement.

La première étape, illustrée par la Fig. 1A, est la fabrication de la chaîne d'éléments supraconducteurs CES (ici, 2000 SQUID SQ formé chacun de deux jonctions Josephson JJ en parallèle) au-dessus d'un substrat SS. Dans l'exemple des figures 1A - 1C le substrat est en silicium et présente une épaisseur de 275 μm ; sa face arrière est couverte d'une couche d'accroche de Ti (10 nm) et d'une couche d'or (200 nm) dont la fonction est essentiellement d'assurer un bon contact thermique avec un porte-échantillon en cuivre (elle forme également un plan de masse, mais dans le cadre de l'invention cette fonction est négligeable).

La chaîne d'éléments supraconducteurs est de préférence réalisée par la technique de « fabrication sans pont » (BFF, de l'anglais « Bridge-Free Fabrication ») décrite dans (Lecocq 2011). Conformément à cette technique, un dégagement fortement asymétrique est formé dans une double couche de résine par lithographie électronique. Un premier dépôt de métal (Al) selon un premier angle par rapport à la normal au substrat permet de fabriques des structure, par exemple en forme de H. Ces structures sont oxydées, puis un deuxième dépôt de métal est réalisé selon un deuxième angle opposé au premier, pour fabriques des structures qui recouvrent partiellement celles déposées auparavant et oxydées. Chaque recouvrement métal oxydé / métal forme une jonction Josephson. Enfin, la résine est enlevé totalement.

Chaque SQUID présente une longueur (dans la direction de propagation des signaux) d'environ 3 $\mu$m et une largeur d'environ 12 $\mu$m.

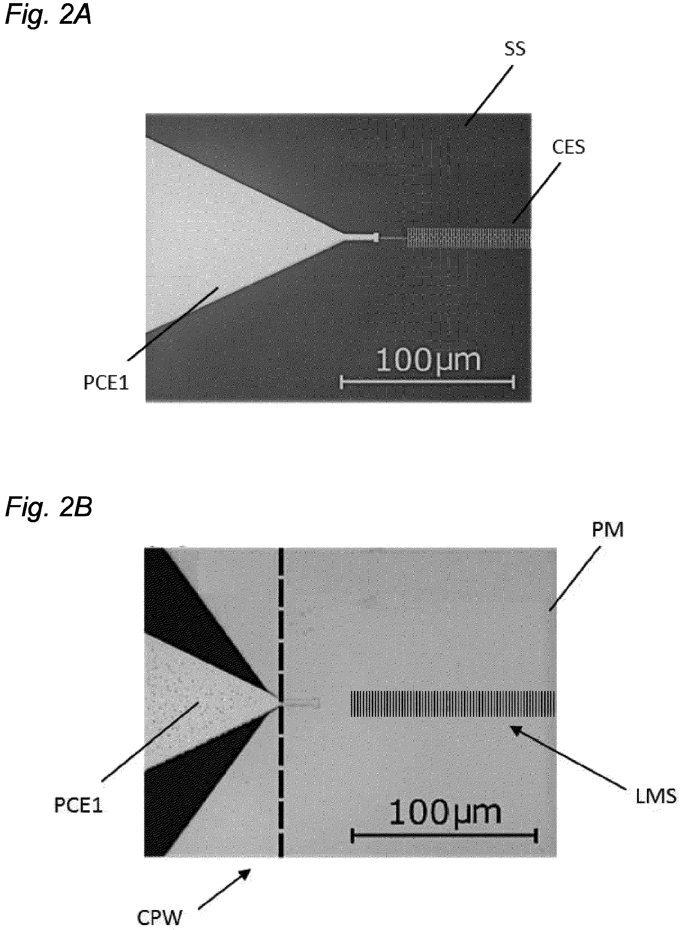

A chaque extrémité, la chaîne CES se termine par une piste de quelques dizaines de micromètres de longueur, puis un plot de contact PCE1, PCE2 de forme effilée (de préférence triangulaire), dont les Fig. 2A et 2B montrent des vues agrandies.

La deuxième étape, illustrée par la Fig. 1B, est le dépôt conforme d'une fine (par exemple, 28 nm) couche diélectrique CD. Dans l'exemple considéré ici, le diélectrique est de l'alumine et le dépôt est effectué par ALD à une température comprise entre 150°C et 200°C en utilisant du trimethylaluminium en tant que précurseur. Il n'est pas nécessaire de prévoir une étape de procédé additionnelle pour masquer les plots de contact : ces derniers peuvent être recouverts par la couche diélectrique qui, en raison de sa faible épaisseur, peut être percée très facilement au moment de la prise de contact (cf. infra, fig. 1C). Ainsi, le dépôt couvre de préférence l'intégralité de la surface du substrat, y compris les plots de contact.

La deuxième étape, illustrée par la Fig. 1C, est le dépôt d'une couche métallique formant un plan de masse PM au-dessus de la couche diélectrique CD. Il peut s'agir par exemple d'une couche d'or de 200 à 1000 nm d'épaisseur. La couche PM forme, avec la couche diélectrique CD et la chaîne d'éléments supraconducteurs CES une ligne de transmission microstrip non linéaire LMS (la non-linéarité étant due aux éléments supraconducteurs) présentant de préférence une impédance caractéristique de 50 Ohm environ (par exemple comprise entre 30 et 70 Ohm, et de préférence entre 30 et 60 Ohm)

La couche PM est structurée, au moment du dépôt ou ultérieurement, de manière à présenter des encoches qui dégagent les plots de contact PCE1, PCE2. Typiquement, la structuration est effectuée par le dépôt préalable d'une couche sacrificielle en résine sur les plots de contact, résine qui est enlevée après le dépôt du métal. Les encoches sont plus larges que les plots de contact, et présentent un angle au sommet plus important, de manière à former avec ces derniers des tronçons de guide d'onde « coplanaire » CPW effilés et adaptés en impédance à la ligne de transmission LMS. Les guides d'onde CPW ne sont pas proprement coplanaires, car les conducteurs centraux (plots PCE1, PCE2) sont déposés directement sur le substrat tandis que les conducteurs latéraux font partie du plan de masse. Toutefois, la couche diélectrique est tellement fine qu'en pratique, du point de vue électromagnétique, on peut considérer la structure comme étant coplanaire. La Fig. 2B montre une vue agrandie de la transition CPW - LMS.

Comme le montre la Fig. 1C, des broches de contact BC sont reliées par microsoudure aux plots de contact PCE1, PCE2 à travers la couche diélectrique CD, qui est facilement percée. Un premier plot est utilisé pour injecter un signal radiofréquence/hyperfréquence à amplifier S à une fréquence $f_S$, ainsi qu'une onde électromagnétique de pompe P, plus intense et présentant une fréquence $f_P$ - toujours radiofréquence/hyperfréquence - supérieure à $f_S/2$. La broche opposée permet de récupérer le signal amplifié, la pompe atténuée et un troisième signal C - dit complémentaire ou « idler » - de fréquence $f_C$. Le principe de conservation de l'énergie impose la relation $2f_P=f_S+f_C$. Sur la Fig. 1C, la référence GP désigne un générateur de pompe.

D'une manière connue en soi, un générateur de champ magnétique GCM, par exemple un électro-aimant, peut induire un champ magnétique d'intensité réglable B, qui traverse les SQUID afin d'ajuster leur inductance. Il est connu, en effet, que l'inductance d'un SQUID est une fonction non-linéaire du flux magnétique qui le traverse. Cela est rendu possible par le fait que le plan de masse, en or, ne devient pas supraconducteur.

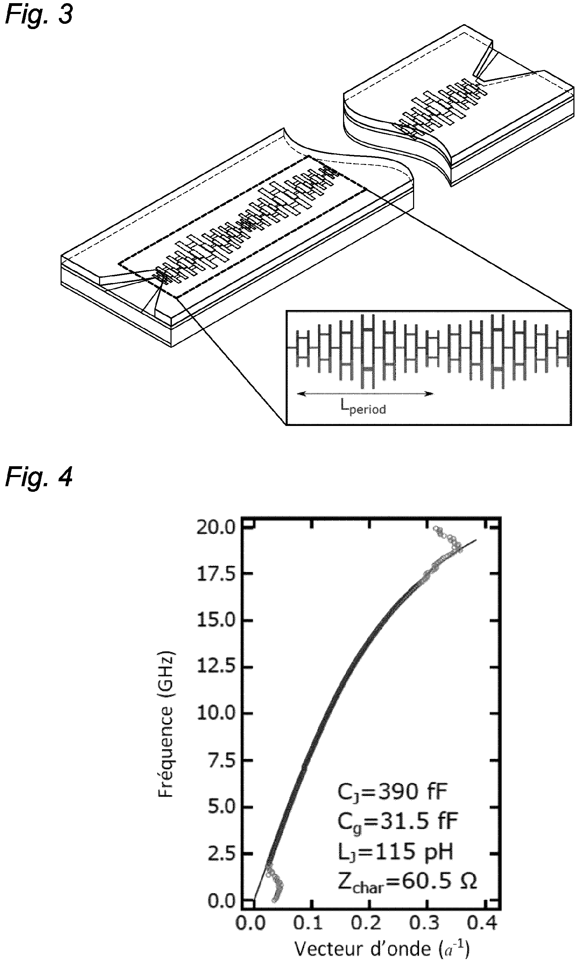

Bien que cela ne soit pas apparent sur les figures, selon un mode de réalisation préféré de l'invention les dimensions des éléments supraconducteurs peuvent être modulées spatialement de manière périodique. Cela modifie la relation de dispersion de la ligne de transmission LMS en introduisant une bande interdite. L'ouverture de cette bande interdite déforme localement la relation de dispersion ce qui permet de manière à assurer, pour un point de fonctionnement (intensité de la pompe) donné et pour une plage de fréquences $f_S$, $f_C$, une condition d'accord de phase. La modulation peut être faible, par exemple d'environ 6% des dimensions des jonctions Josephson. La figure 3 illustre un amplificateur paramétrique selon un mode de réalisation de l'invention dans lequel les éléments supraconducteurs (SQUID) présentent une modulation de dimensions (largeur) avec une période $L_{period}$. Il est intéressant de noter que l'introduction d'une modulation spatiale des dimensions des éléments supraconducteurs n'introduit pas d'étapes de procédé additionnelles.

La relation de dispersion de la ligne de transmission LMS a été mesurée en utilisant la méthode décrite dans (Macklin 2015). Le résultat de la mesure est illustré sur la Fig. 4. On peut en déduire les valeurs de la capacité des jonctions Josephson $C_J$ (390 fF), leur inductance $L_J$ (115 pH) la capacité à la masse $C_g$ (31,5 fF) et l'impédance caractéristique (racine carrée de $L_J/C_g$=60,5 Ohm environ). On vérifie qu'une impédance caractéristique proche de la valeur cible de 50 Ohm est obtenue (il s'agit là d'un prototype, un meilleur contrôle des conditions de fabrication permet de s'approcher davantage de cette valeur cible). Il est intéressant de noter que cette valeur d'impédance est obtenue avec des cellules élémentaires très petites, ayant une longueur d'environ 3,2 $\mu$m, contre 16 $\mu$m pour (Macklin 2015) ; dans (White 2015) une cellule élémentaire comprend 3 jonctions Josephson et une capacité et mesure 67 $\mu$m, soit environ 22 $\mu$m par jonction Josephson. On voit donc bien l'avantage procuré par l'invention en termes de miniaturisation.

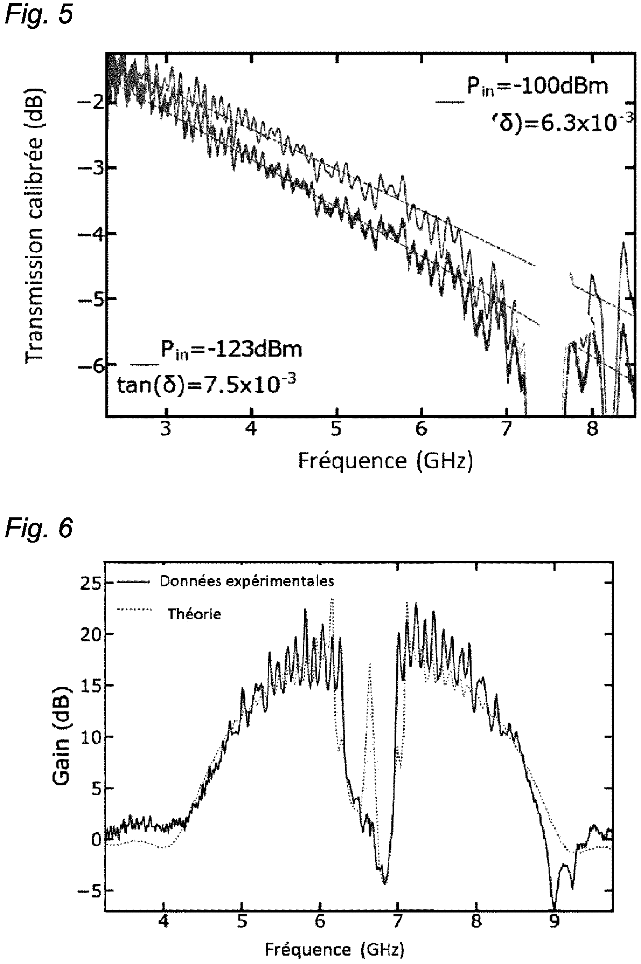

La Fig. 5 montre deux courbes de transmission de la ligne LMS pour deux valeurs différentes de l'intensité de l'onde de pompe : -100 dBm (courbe supérieure) et -123 dBm. On peut remarquer que les pertes diminuent lorsque l'intensité de la pompe augmente. Ces courbes expérimentales permettent de calculer un angle de perte $\tan\delta\sim\delta$ compris entre $6,3\cdot10^{-3}$ et $7,5\cdot10^{-3}$, ce qui confirme l'excellente qualité du diélectrique obtenu par ALD.

La figure 6 illustre une courbe de gain mesurée sur le dispositif des figures 4 et 5 (ligne continue) et la courbe théorique de gain (ligne pointillée). En faisant abstraction des ondulations, on peut observer que le gain atteint les 18 dB avec une bande passante à -3dB d'environ 3 GHz, coupée en son milieu par une bande interdite d'environ 700 MHz.

L'invention a été décrite en référence à un mode de réalisation particulier. Elle ne se limite cependant à ce mode de réalisation, et de nombreuses variantes conformes à l'étendue de la protection définie par les revendications sont possibles.

D'autres matériaux que ceux indiqués (silicium pour le substrat, aluminium pour la réalisation des jonctions Josephson, alumine pour le diélectrique et or pour le plan de masse) peuvent être utilisés. En particulier, s'il n'est pas nécessaire d'utiliser un flux magnétique pour accorder finement les inductances des jonctions Josephson, le plan de masse peut être à son tour supraconducteur.

D'autres techniques que la BFF peuvent être utilisées pour la fabrication des jonctions Josephson - par exemple, une technique avec formation d'un pont de résine.

L'utilisation d'une modulation spatiale des dimensions des éléments supraconducteurs pour obtenir l'accord de phase est particulièrement avantageuse car elle n'entraîne aucune augmentation de l'encombrement de l'amplificateur paramétrique. Cependant, d'autres techniques, comme par exemple l'insertion de résonateurs, peuvent également être utilisées.

Références bibliographiques

(Planat 2018) L. Planat et al. "Understanding the saturation power of Josephson Parametric Amplifier made from SQUIDs arrays", arXiv: 1809.08746v1.

(Shan 2016)

SHAN WENLEI ET AL: "Parametric Amplification in a Superconducting Microstrip Transmission Line", IEEE TRANSACTIONS ON APPLIED SUPERCONDUCTIVITY
(Eom 2012): Byeong Ho Eom et al. « A wideband, low-noise superconducting amplifier with high dynamic range » Nature Physics 8.8 (2012): 623
(White 2015): T. C. White et al. « Travelling wave parametric amplifier with Josephson jonctions using minimal resonator phase matching », Appl. Phys. Lett. 106, 242601 (2015)
(Macklin 2015) : C. Macklin et al. « A near-quantum-limited Josephson travaling-wave parametric amplifier », Science, Vol. 350, Issue 6258, pages 307 - 310, 16 octobre 2015
(Lecocq 2011) : F. Lecocq et al. « Jonction fabrication by shadow évaporation without a suspended bridge » Nanotechnology 22, 315302 (2011).

Revendications

1. Amplificateur paramétrique supraconducteur à onde progressive comprenant une chaîne (CES) d'éléments supraconducteurs (JJ, SQ) présentant une inductance cinétique non linéaire reliés en série, lesdits éléments supraconducteurs étant déposés sur un substrat (SS), comprenant également une couche diélectrique (CD) d'épaisseur submicrométrique déposée sur le substrat et recouvrant lesdits éléments supraconducteurs, ainsi qu'une couche conductrice (PM) formant un plan de masse déposée au-dessus de la couche diélectrique, les éléments supraconducteur et le plan de masse formant une ligne de transmission de type microstrip (LMS) ; **caractérisé en ce que** lesdits éléments supraconducteurs sont choisis parmi des jonctions Josephson (JJ) et des SQUID (SQ), et **en ce que** ladite couche diélectrique est réalisée par dépôt de couches atomiques.

2. Amplificateur paramétrique supraconducteur à onde progressive selon la revendication 1 dans lequel ladite couche diélectrique présente une épaisseur comprise entre 1 et 100 nm, et de préférence entre 10 et 50 nm.

3. Amplificateur paramétrique supraconducteur à onde progressive selon l'une des revendications précédentes dans lequel ladite couche diélectrique est en alumine.

4. Amplificateur paramétrique supraconducteur à onde progressive selon l'une des revendications précédentes dans lequel la chaîne d'éléments supraconducteurs et l'épaisseur de la couche diélectrique sont dimensionnés de telle sorte que la ligne de transmission présente une impédance comprise entre 30 et 70 Ohm, et de préférence entre 30 et 60 Ohm.

5. Amplificateur paramétrique supraconducteur à onde progressive selon l'une des revendications précédentes comprenant également au moins un plot de contact conducteur de forme effilée (PCE1, PCE2) dont l'extrémité plus fine est reliée électriquement à une extrémité de la chaîne d'éléments supraconducteurs, dans lequel la couche conductrice formant un plan de masse est structurée pour former, avec ledit plot de contact conducteur, un tronçon de ligne de transmission de type coplanaire (CPW) adapté en impédance à la ligne de transmission de type microstrip.

6. Amplificateur paramétrique supraconducteur à onde progressive selon la revendication 5 comprenant également au moins une broche de contact (BC) reliée électriquement audit ou à chaque plot de contact à travers la couche diélectrique.

7. Amplificateur paramétrique supraconducteur à onde progressive selon l'une des revendications 5 ou 6 dans lequel la couche conductrice (PM) est structurée pour former lesdits plots de contact (PCE1, PCE2) par dépôt préalable d'une couche sacrificielle en résine sur les plots de contact, résine qui est enlevée après le dépôt du métal.

8. Amplificateur paramétrique supraconducteur à onde progressive selon l'une des revendications précédentes dans lequel au moins une dimension desdits éléments supraconducteurs présentant une inductance cinétique non linéaire est modulée spatialement de manière à définir une plage spatiale d'accord de phase pour une onde électromagnétique.

9. Amplificateur paramétrique supraconducteur à onde progressive selon l'une des revendications précédentes comprenant également un générateur (GP) d'un signal de pompe à radiofréquence ou hyperfréquence.

10. Amplificateur paramétrique supraconducteur à onde progressive selon l'une des revendications précédentes dans lequel lesdits éléments supraconducteurs présentant une inductance cinétique non linéaire sont des SQUID, comprenant également une source de champ magnétique variable (GCM) générant un flux ajustable à travers lesdits SQUID.

11. Procédé de fabrication d'un amplificateur paramétrique à onde progressive selon l'une des revendications précédentes comprenant les étapes consistant à :

   a) fabriquer sur un substrat (SS), par des opérations de lithographie électronique, dépôt métallique et oxydation, une chaîne (CES) d'éléments supraconducteurs de type jonctions Josephson (JJ) ou SQUID (SQ) reliés en série ;
   b) réaliser, par dépôt de couches atomiques au-dessus dudit substrat, une couche diélectrique (CD) d'épaisseur sub-micrométrique recouvrant lesdits éléments supraconducteurs ; et
   c) déposer une couche conductrice (PM) formant un plan de masse au-dessus de la couche diélectrique.

12. Procédé de fabrication selon la revendication 11 dans lequel l'étape a) comprend également la fabrication d'au moins un plot de contact conducteur de forme effilée (PCE1, PCE2) dont l'extrémité plus fine est reliée électriquement à une extrémité de la chaîne d'éléments supraconducteurs, et l'étape c) comprend également une structuration de la couche conductrice pour former, avec ledit plot de contact conducteur, un tronçon de ligne d'onde de type coplanaire (CPW) adapté en impédance à la ligne de transmission de type microstrip formée par la chaîne d'éléments supraconducteurs et le plan de masse.

**13.** Procédé de fabrication selon la revendication 12 comprenant également l'étape suivante :

d) connexion d'une broche de contact (BC) audit ou à chaque dit plot de contact par microsoudure à travers la couche diélectrique.

**14.** Procédé de fabrication selon l'une des revendications 12 ou 13 dans lequel, dans l'étape c), ladite structuration de la couche conductrice est effectuée par le dépôt préalable d'une couche sacrificielle en résine sur les plots de contact, résine qui est enlevée après le dépôt du métal.

## Patentansprüche

**1.** Supraleitender Wanderwellenreaktanzverstärker, umfassend eine Kette (CES) supraleitender Elemente (JJ, SQ), die eine nichtlineare kinetische Induktivität aufweisen, die in Reihe geschaltet sind, wobei die supraleitenden Elemente auf einem Substrat (SS) abgeschieden sind, auch umfassend eine dielektrische Schicht (CD) mit einer submikrometrischen Dicke, die auf dem Substrat abgeschieden ist und die supraleitenden Elemente bedeckt, sowie eine leitende Schicht (PM), die eine Masseebene ausbildet, die über der dielektrischen Schicht abgeschieden ist, wobei die supraleitenden Elemente und die Masseebene eine Übertragungsleitung (LMS) einer Mikrostripart ausbilden; **dadurch gekennzeichnet, dass** die supraleitenden Elemente aus Josephson-Übergängen (JJ) und SQUIDs (SQ) ausgewählt sind und **dass** die dielektrische Schicht durch Abscheidung von Atomschichten erstellt wird.

**2.** Supraleitender Wanderwellenreaktanzverstärker nach Anspruch 1, wobei die dielektrische Schicht eine Dicke zwischen 1 und 100 nm und vorzugsweise zwischen 10 und 50 nm aufweist.

**3.** Supraleitender Wanderwellenreaktanzverstärker nach einem der vorstehenden Ansprüche, wobei die dielektrische Schicht aus Aluminiumoxid besteht.

**4.** Supraleitender Wanderwellenreaktanzverstärker nach einem der vorstehenden Ansprüche, wobei die Kette supraleitender Elemente und die Dicke der dielektrischen Schicht so bemessen sind, dass die Übertragungsleitung eine Impedanz zwischen 30 und 70 Ohm und vorzugsweise zwischen 30 und 60 Ohm aufweist.

**5.** Supraleitender Wanderwellenreaktanzverstärker nach einem der vorstehenden Ansprüche, auch umfassend mindestens ein leitendes Kontaktstück (PCE1, PCE2) mit konisch zulaufender Form, dessen dünneres Ende mit einem Ende der Kette supraleitendender Elemente elektrisch verbunden ist, wobei die leitende Schicht, die eine Masseebene ausbildet, strukturiert ist, um mit dem leitenden Kontaktstück einen Abschnitt einer Übertragungsleitung (CPW) einer koplanaren Art auszubilden, der an die Übertragungsleitung der Mikrostripart impedanzangepasst ist.

**6.** Supraleitender Wanderwellenreaktanzverstärker nach Anspruch 5, auch umfassend mindestens einen Kontaktstift (BC), der über die dielektrische Schicht mit dem oder mit jedem Kontaktstück elektrisch verbunden ist.

**7.** Supraleitender Wanderwellenreaktanzverstärker nach einem der Ansprüche 5 oder 6, wobei die leitende Schicht (PM) strukturiert ist, um die Kontaktstücke (PCE1, PCE2) durch vorheriges Abscheiden einer Opferharzschicht auf die Kontaktstücke auszubilden, wobei das Harz nach der Abscheidung des Metalls entfernt wird.

**8.** Supraleitender Wanderwellenreaktanzverstärker nach einem der vorstehenden Ansprüche, wobei mindestens eine Abmessung der supraleitenden Elemente, die eine nichtlineare kinetische Induktivität aufweisen, räumlich moduliert ist, um einen räumlichen Bereich der Phasenanpassung für eine elektromagnetische Welle zu definieren.

**9.** Supraleitender Wanderwellenreaktanzverstärker nach einem der vorstehenden Ansprüche, auch umfassend einen Generator (GP) eines Hochfrequenz- oder Funkfrequenzpumpsignals.

**10.** Supraleitender Wanderwellenreaktanzverstärker nach einem der vorstehenden Ansprüche, wobei die supraleitenden Elemente, die eine nichtlineare kinetische Induktivität aufweisen, SQUIDs sind, auch umfassend eine variable Magnetfeldquelle (GCM), die einen einstellbaren Fluss durch die SQUID erzeugt.

**11.** Verfahren zum Herstellen eines Wanderwellenreaktanzverstärkers nach einem der vorstehenden Ansprüche, umfassend die Schritte, bestehend aus:

a) Herstellen, auf einem Substrat (SS), durch Vorgänge der elektronischen Lithographie, Metallabscheidung und Oxidation, einer Kette (CES) supraleitender Elemente der Art von Josephson-Übergängen (JJ) oder SQUIDs (SQ), die in Reihe geschaltet sind;

b) Erstellen, durch Abscheidung von Atomschichten über dem Substrat, einer dielektrischen Schicht (CD) mit einer submikrometrischen Dicke, die die supraleitenden Elemente bedeckt; und

c) Abscheiden einer leitenden Schicht (PM), die eine Masseebene über der dielektrischen Schicht ausbildet.

12. Herstellungsverfahren nach Anspruch 11, wobei Schritt a) auch das Herstellen mindestens eines leitenden Kontaktstücks (PCE1, PCE2) mit konisch zulaufender Form umfasst, dessen dünneres Ende mit einem Ende der Kette supraleitendender Elemente elektrisch verbunden ist, und Schritt c) auch eine Strukturierung der leitenden Schicht umfasst, um mit dem leitenden Kontaktstück einen Abschnitt einer koplanaren Wellenleitung (CPW) auszubilden, der an die Übertragungsleitung der Mikrostripart impedanzangepasst, die durch die Kette supraleitender Elemente und die Masseebene ausgebildet wird.

13. Herstellungsverfahren nach Anspruch 12, auch umfassend den folgenden Schritt:

d) Verbinden eines Kontaktstifts (BC) mit dem oder mit jedem Kontaktstück durch Mikroschweißen durch die dielektrische Schicht.

14. Herstellungsverfahren nach einem der Ansprüche 12 oder 13, wobei in Schritt c) die Strukturierung der leitenden Schicht durch vorheriges Abscheiden einer Harzopferschicht auf den Kontaktstücken erfolgt, wobei das Harz nach der Abscheidung des Metalls entfernt wird.

## Claims

1. A traveling wave superconducting parametric amplifier comprising a chain (CES) of superconducting elements (JJ, SQ) having a nonlinear kinetic inductance connected in series, said superconducting elements being deposited on a substrate (SS), further comprising a dielectric layer (CD) of sub-micrometer thickness deposited on the substrate and covering said superconducting elements, and a conductive layer (PM) forming a ground plane deposited on top of the dielectric layer, the superconducting elements and the ground plane forming a microstrip-type transmission line (LMS); **characterized in that** said superconducting elements are selected from Josephson junctions (JJ) and SQUIDs (SQ), and **in that** said dielectric layer is produced by atomic layer deposition.

2. The traveling wave superconducting parametric amplifier as claimed in claim 1, wherein said dielectric layer has a thickness of between 1 and 100 nm, and preferably of between 10 and 50 nm.

3. The traveling wave superconducting parametric amplifier as claimed in one of the preceding claims, wherein said dielectric layer is made of alumina.

4. The traveling wave superconducting parametric amplifier as claimed in one of the preceding claims, wherein the chain of superconducting elements and the thickness of the dielectric layer are dimensioned such that the transmission line has an impedance of between 30 and 70 Ohms, and preferably of between 30 and 60 Ohms.

5. The traveling wave superconducting parametric amplifier as claimed in one of the preceding claims, further comprising at least one tapered conductive contact pad (PCE1, PCE2), the thinner end of which is electrically connected to one end of the chain of superconducting elements, in which the conductive layer forming a ground plane is structured so as to form, with said conductive contact pad, a coplanar-type transmission line segment (CPW) impedance-matched to the microstrip-type transmission line.

6. The traveling wave superconducting parametric amplifier as claimed in claim 5, further comprising at least one contact pin (BC) that is electrically connected to said or to each contact pad through the dielectric layer.

7. The traveling wave superconducting parametric amplifier as claimed in one of the claims 5 or 6, wherein the conductive layer (PM) is arranged to form said contact pad (PCE1, PCE2) by previously depositing a sacrificial layer in resin on the contact pads, which resin is removed after the metal has been deposited.

8. The traveling wave superconducting parametric amplifier as claimed in one of the preceding claims, wherein at least one dimension of said superconducting elements exhibiting a nonlinear kinetic inductance is spatially modulated so as to define a phase-matching spatial range for an electromagnetic wave.

9. The traveling wave superconducting parametric amplifier as claimed in one of the preceding claims, further comprising a generator (GP) of a microwave-frequency or radiofrequency pump signal.

10. The traveling wave superconducting parametric amplifier as claimed in one of the preceding claims, wherein said superconducting elements exhibiting a nonlinear kinetic inductance are SQUIDs, further comprising a variable magnetic field source (GCM) generating an adjustable flux through said SQUIDs.

11. A method for producing a traveling wave parametric amplifier as claimed in one of the preceding claims, comprising the steps of:

   a) producing, on a substrate (SS), using electron beam lithography, metal deposition and oxidation operations, a chain (CES) of superconducting elements of Josephson junction (JJ) or SQUID (SQ) type connected in series;
   b) producing, by way of atomic layer deposition on top of said substrate, a dielectric layer (CD) of sub-micrometer thickness covering said superconducting elements; and
   c) depositing a conductive layer (PM) forming a ground plane on top of the dielectric layer.

12. The production method as claimed in claim 11, wherein step a) further comprises producing at least one tapered conductive contact pad (PCE1, PCE2), the thinner end of which is electrically connected to one end of the chain of superconducting elements, and step c) further comprises a structuring of the conductive layer so as to form, with said conductive contact pad, a coplanar-type wave line segment (CPW) impedance-matched to the microstrip-type transmission line formed by the chain of superconducting elements and the ground plane.

13. The production method as claimed in claim 12, further comprising the following step of:
   d) connecting a contact pin (BC) to said or to each said contact pad by microsoldering through the dielectric layer.

14. The production method as claimed in one of claims 12 or 13, wherein, in step c), said structuring of the conductive layer comprises previously depositing a sacrificial layer in resin on the contact pads, which resin is removed after the metal has been deposited.

## Fig. 1A

## Fig. 1B

## Fig. 1C

*Fig. 2A*

*Fig. 2B*

*Fig. 3*

$L_{period}$

*Fig. 4*

$C_J = 390$ fF
$C_g = 31.5$ fF
$L_J = 115$ pH
$Z_{char} = 60.5$ $\Omega$

Fréquence (GHz)

Vecteur d'onde ($a^{-1}$)

*Fig. 5*

*Fig. 6*

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20120098594 A

- US 20180034425 A

**Littérature non-brevet citée dans la description**

- **L. PLANAT et al.** Understanding the saturation power of Josephson Parametric Amplifier made from SQUIDs arrays. *arXiv: 1809.08746v1*
- **SHAN WENLEI et al.** Parametric Amplification in a Superconducting Microstrip Transmission Line. *IEEE TRANSACTIONS ON APPLIED SUPERCONDUCTIVITY*
- **BYEONG HO EOM et al.** A wideband, low-noise superconducting amplifier with high dynamic range. *Nature Physics,* 2012, vol. 8 (8), 623

- **T. C. WHITE et al.** Travelling wave parametric amplifier with Josephson jonctions using minimal resonator phase matching. *Appl. Phys. Lett.,* 2015, vol. 106, 242601
- **C. MACKLIN et al.** A near-quantum-limited Josephson travaling-wave parametric amplifier. *Science,* 16 Octobre 2015, vol. 350 (6258), 307-310
- **F. LECOCQ et al.** Jonction fabrication by shadow évaporation without a suspended bridge. *Nanotechnology,* 2011, vol. 22, 315302